(19) Europäisches Patentamt
European Patent Office
Office européen des brevets

(11) **EP 1 771 891 B1**

(12) **EUROPÄISCHE PATENTSCHRIFT**

(45) Veröffentlichungstag und Bekanntmachung des Hinweises auf die Patenterteilung:
**11.11.2015 Patentblatt 2015/46**

(21) Anmeldenummer: **05770747.3**

(22) Anmeldetag: **21.07.2005**

(51) Int Cl.:
*H01L 33/58* (2010.01)    *H01L 33/60* (2010.01)
*H01L 25/075* (2006.01)    *F21S 8/10* (2006.01)

(86) Internationale Anmeldenummer:
**PCT/DE2005/001283**

(87) Internationale Veröffentlichungsnummer:
**WO 2006/012842 (09.02.2006 Gazette 2006/06)**

(54) **LICHTEMITTIERENDES BAUELEMENT UND LEUCHTMODUL**

LIGHT EMITTING COMPONENT AND ILLUMINATION MODULE

ELEMENT ÉLECTROLUMINESCENT ET MODULE LUMINEUX

(84) Benannte Vertragsstaaten:
**DE**

(30) Priorität: **26.07.2004 DE 102004036157**

(43) Veröffentlichungstag der Anmeldung:
**11.04.2007 Patentblatt 2007/15**

(73) Patentinhaber: **OSRAM Opto Semiconductors GmbH**
**93055 Regensburg (DE)**

(72) Erfinder:
- **BOGNER, Georg**
  **93138 Lappersdorf (DE)**
- **ENGL, Moritz**
  **93055 Regensburg (DE)**
- **GRÖTSCH, Stefan**
  **93077 Lengfeld/Bad Abbach (DE)**
- **KROMOTIS, Patrick**
  **93059 Regensburg (DE)**

(74) Vertreter: **Epping - Hermann - Fischer Patentanwaltsgesellschaft mbH Schloßschmidstraße 5 80639 München (DE)**

(56) Entgegenhaltungen:
EP-A- 1 103 759        EP-A- 1 447 617
EP-A- 1 502 752        EP-A- 1 526 581
WO-A-2004/088201       US-A- 5 727 108
US-A1- 2003 234 431

- PATENT ABSTRACTS OF JAPAN Bd. 2003, Nr. 05, 12. Mai 2003 (2003-05-12) & JP 2003 031011 A (STANLEY ELECTRIC), 31. Januar 2003 (2003-01-31)
- PATENT ABSTRACTS OF JAPAN Bd. 2003, Nr. 02, 5. Februar 2003 (2003-02-05) & JP 2002 314146 A (TOYODA GOSEI; MATSUSHITA ELECTRIC IND), 25. Oktober 2002 (2002-10-25)
- PATENT ABSTRACTS OF JAPAN Bd. 1998, Nr. 04, 31. März 1998 (1998-03-31) & JP 09 321341 A (NICHIA CHEM IND LTD), 12. Dezember 1997 (1997-12-12)

**Beschreibung**

Die Erfindung betrifft ein lichtemittierendes gemäß dem Oberbegriff von Anspruch 1 sowie ein Leuchtmodul mit einem derartigen Bauelement.

In der EP 0 933 823 A2 ist ein oberflächenmontierbares optoelektronisches Bauelement offenbart. Dieses weist einen Leiterrahmen aus zwei metallischen Bändern sowie einen Leuchtdiodenchip auf, der auf einem der metallischen Bänder montiert und mit dem anderen der metallischen Bänder mittels eines Kontaktdrahtes elektrisch leitend verbunden ist. Das Bauelement hat weiterhin ein Gehäuse mit einem quaderförmigen Bodenteil, das von unten an den Leiterrahmen geklebt ist, sowie einem rechteckigen Rahmenteil, das von oben auf dem Leiterrahmen befestigt wird. Das Rahmenteil definiert eine Gehäusekavität, die mit einer strahlungsdurchlässigen Abdeckung abgedeckt wird.

Für viele Anwendungen, wie beispielsweise Leuchten oder Lampen, reicht die Strahlungsintensität eines einzigen strahlungsemittierenden Halbleiterchips nicht aus, sondern es wird eine Mehrzahl von Halbleiterchips benötigt. In solchen Fällen wird häufig eine Mehrzahl von Bauelementen mit jeweils einem Halbleiterchip verwendet. Dies ist in der EP 0 933 823 A2 beschrieben. Hierbei dienen die einzelnen Bauelemente als Einzelpixel, die beispielsweise für eine Flächenleuchte matrixartig angeordnet werden oder mittels denen eine kugelförmige Lampe gebildet wird, bei der mehrere Einzelpixel bzw. Bauelemente um einen Zuleitungsstab herum gruppiert sind.

Während derartige Lampen für allgemeine Beleuchtungszwecke gut geeignet sein können, ist ihre Eignung für Anwendungen, bei denen eine möglichst hohe Leuchtdichte sowie ein möglichst geringer Abstrahlwinkel erforderlich ist, beschränkt. Beispielsweise sind bei einer Verwendung einzelner Bauelemente einer möglichst dichten und kompakten Anordnung mehrerer Halbleiterchips Grenzen gesetzt, was allein schon durch die Größe der Bauelement-Gehäuse bedingt ist. Zudem ist es erforderlich, jedes einzelne Bauelement elektrisch anzuschließen, was ebenfalls Platz kostet und relativ aufwendig sein kann und wodurch Platzbedarf und Herstellungsaufwand weiter steigen.

In der Druckschrift JP 2003 031011 ist eine Lichtquelle offenbart, bei der eine Mehrzahl von Halbleiterchips in einer linienförmigen Anordnung angeordnet sind, wobei zwei benachbarte Halbleiterchips zueinander einen Abstand des 1,3-fachen der lateralen Kantenlänge der Halbleiterchips aufweisen.

In der Druckschrift EP 1 103 759 A2 ist eine RGB-Lichtquelle offenbart, bei der rotes, grünes und blaues Licht emittierende Leuchtdiodenchips gemeinsam in einer Kavität angeordnet sind, die in einer Hinterleuchtungseinheit für einen LCD-Bildschirm verwendet wird. Die Hinterleuchtungseinheit weist weiterhin einen Lichtleitteil mit einer Lichtleitplatte, einer reflektierenden Platte und einer Diffusorplatte auf.

In der Druckschrift US 5,727,108 A ist ein zusammengesetzter parabolischer Konzentrator ("compound parabolic concentrator", CPC) beschrieben.

Es ist Aufgabe der vorliegenden Erfindung, ein Bauelement bereitzustellen, das eine kompakte Anordnung von Halbleiterchips ermöglicht und das insbesondere eine Abstrahlcharakteristik aufweist, die für Scheinwerferapplikationen wie beispielsweise Automobilscheinwerfer geeignet ist, bei denen eine hohe Leuchtdichte, ein enger Abstrahlwinkel und eine wohldefinierte, spezielle Form des Abstrahlkegels erforderlich ist.

Diese Aufgabe wird durch ein Bauelement gemäß Anspruch 1 gelöst. Vorteilhafte Ausführungsformen und bevorzugte Weiterbildungen des Bauelements sind Gegenstand der abhängigen Patentansprüche.

Erfindungsgemäß ist bei einem Bauelement der eingangs, genannten Art eine grabenartige Kavität ausgebildet, wobei in der Kavität eine Mehrzahl von Halbleiterchips in einer linienförmigen Anordnung angeordnet sind.

Durch die linienförmige Anordnung der Halbleiterchips kann man eine Form eines von dem Bauelement emittierten Strahlungskegels erreichen, die für viele Anwendungen vorteilhaft ist. So ist es möglich, dass ein Querschnitt des Strahlungskegels eine relativ große Länge und eine verglichen damit kleine Breite aufweist, was z.B. für die Anwendung in Autoscheinwerfern vorteilhaft ist, bei denen vertikal ein relativ kleiner Raumwinkel, horizontal jedoch die Fahrbahn in ihrer vollen Breite, d.h. ein relativ großer Raumwinkel ausgestrahlt werden soll.

Bei dem Bauelement weisen zwei benachbarte Halbleiterchips zueinander vorteilhafterweise einen Abstand auf, der kleiner als oder gleich dem 1,5-fachen der lateralen Kantenlänge der Halbleiterchips und größer als oder gleich 0 $\mu$m ist. Durch die enge Anordnung der Halbleiterchips eignet sich das Bauelement zur Erzeugung eines möglichst homogenen Strahlungskegels, der in einen möglichst engen Raumwinkel emittiert wird, so dass eine möglichst hohe Strahlungsintensität auf eine möglichst kleine Fläche projiziert werden kann. Unter einer lateralen Kantenlänge ist ein Abstand einander gegenüber liegender Chipkanten der Halbleiterchips zu verstehen, der in Richtung der Anordnung der Halbleiterchips gemessen ist.

Bevorzugt weisen die benachbarten Halbleiterchips zueinander einen Abstand von kleiner als oder gleich 300 $\mu$m, besonders bevorzugt von kleiner als oder gleich 100 $\mu$m und größer als oder gleich 0 $\mu$m auf.

Zweckmäßigerweise sind die Halbleiterchips auf einer gedruckten Leiterplatte (PCB) oder auf einem Leiterrahmen angeordnet.

Mit besonderem Vorteil weist der Gehäusekörper auf einer Seite entlang der Anordnung der Halbleiterchips eine die Kavität begrenzende Innenwand auf, wobei zumindest ein Abschnitt der Innenwand als eine Blendenwand ausgebildet ist, die für mindestens einen Spektralbereich des emittierten Lichts reflektierend ist. Durch eine derartige Blendenwand kann die Emission der Strahlung in einen unerwünschten Raumbereich unterdrückt werden. Hierzu verläuft die Blendenwand zweckmäßigerweise im wesentlichen in einem Winkel von größer als oder gleich 80° und kleiner als oder gleich 110° zu einer Montageebene der Halbleiterchips. Insbesondere verläuft die Blendenwand im wesentlichen senkrecht zu der Montageebene.

Die Halbleiterchips sind mit Vorteil in einem Abstand von kleiner als oder gleich 1 mm, bevorzugt von kleiner als oder gleich 500 $\mu$m, besonders bevorzugt von kleiner als oder gleich 150 $\mu$m und größer als oder gleich 0 mm zu der Blendenwand angeordnet. Durch einen geringen Abstand der Halbleiterchips zu der Blendenwand trifft ein Teil des Strahlungskegels mit einer relativ hohen Strahlungsdichte auf die Blendenwand, so dass eine effektive Abschirmung erzielt werden kann, mit der gleichzeitigen Möglichkeit, die Strahlung zu einem niederdivergenten Strahlungskegel von hoher Strahlungsdichte zu formen.

Die Anordnung der Halbleiterchips weist in einer bevorzugten Ausführungsform des Bauelements ein erstes und ein zweites Ende auf, wobei an dem ersten Ende mindestens zwei Halbleiterchips entlang einer ersten Geraden angeordnet sind, die gegenüber einer zweiten Geraden geneigt ist, entlang der mindestens zwei Halbleiterchips an dem zweiten Ende angeordnet sind. Besonders bevorzugt ist die erste Gerade gegenüber der zweiten Gerade um einen Neigungswinkel von kleiner als oder gleich 20° und größer als oder gleich 10°, insbesondere von etwa 15° geneigt. Ein derart beschaffenes Bauelement eignet sich wiederum insbesondere für die Anwendung eines Kfz-Scheinwerfers.

Gemäß dem deutschen Standard ECE muss der Scheinwerferkegel eines Autoscheinwerfers einerseits auf der in Abstrahlrichtung des Scheinwerfers linken Seite eine horizontal verlaufende Obergrenze aufweisen, derart, dass Fahrer entgegenkommender Fahrzeuge nicht geblendet werden. Die rechte Seite des Scheinwerferkegels weist dagegen eine Obergrenze auf, die in einer um 15° gegenüber der Horizontalen verkippten Ebene liegt, derart, dass der in Fahrtrichtung rechts liegende Teil der Straße oder des Straßenrandes besser bzw. in Fahrtrichtung weiter durch den Scheinwerfer ausgeleuchtet ist als der linke Teil. Ein Scheinwerfer mit derartigen Eigenschaften kann mit dem Bauelement auf einfache Weise realisiert werden.

Bei dem Bauelement ist mindestens ein optisches Element vorgesehen, das eine Divergenz der elektromagnetischen Strahlung verringert und das den Halbleiterchips gemeinsam zugeordnet ist.

Das optische Element ist ein nichtabbildender optischer Konzentrator, wobei ein Strahlungseingang des optischen Elementes der eigentliche Konzentratorausgang ist, so dass die Strahlung verglichen mit der üblichen Anwendung eines Konzentrators zum Fokussieren in umgekehrter Richtung durch diesen läuft und somit nicht konzentriert wird, sondern den Konzentrator mit verringerter Divergenz durch einen Strahlungsausgang des optischen Elementes verlässt.

Der Strahlungseingang weist bevorzugt eine Strahlungseingangsfläche oder eine Strahlungseingangsöffnung auf, die eine Breite von kleiner als oder gleich 1,5 mal einer lateralen Kantenlänge der Halbleiterchips, bevorzugt von kleiner als oder gleich 1,25 mal der Kantenlänge aufweist. Unter einer lateralen Kantenlänge ist eine Ausdehnung des Halbleiterchips senkrecht zu seiner Hauptabstrahlrichtung zu verstehen.

Ein derart kleiner Strahlungseingang ist vorteilhaft, um den Raumwinkel, in den die elektromagnetische Strahlung emittiert wird, mit dem optischen Element möglichst nah am Halbleiterchip zu verkleinern, wo eine Querschnittsfläche des Strahlenkegels klein ist. Dies ist insbesondere dann erforderlich, wenn das Bauelement geeignet sein soll, eine möglichst hohe Strahlungsstärke auf eine möglichst kleine Fläche zu projizieren. Eine wichtige Erhaltungsgröße in der geometrischen Optik ist dabei das Etendue, d.h. die Strahldichte. Sie ist das Produkt aus dem Flächeninhalt einer Lichtquelle und dem Raumwinkel, in den sie abstrahlt. Die Erhaltung des Etendue hat unter anderem zur Konsequenz, dass man das Licht einer diffusen Strahlungsquelle, zum Beispiel einer Halbleiterleuchtdiode, nicht mehr konzentrieren, d.h. nicht mehr auf eine Fläche mit kleinerer Ausdehnung umlenken kann, weshalb es vorteilhaft ist, wenn das Strahlungsbündel mit einem möglichst kleinen Querschnitt in das optische Element eintritt.

Damit bei einem kleinen Strahlungseingang die gesamte von einem Halbleiterchip emittierte Strahlung in das optische Element gelangen kann, ist es entsprechend erforderlich, den Strahlungseingang möglichst nah an den Halbleiterchip zu bringen.

Das optische Element verringert die Divergenz des Strahlenkegels in einer Ebene senkrecht zu einer Linie, entlang der, die Halbleiterchips angeordnet sind, derart, dass der Strahlenkegel einen Öffnungswinkel zwischen 0 und 30°, bevorzugt zwischen 0 und 20°, besonders bevorzugt zwischen 0 und 10° aufweist, wobei die Grenzen jeweils einbezogen sind.

Hierfür ist der Konzentrator ein CPC-, CEC- oder CHC-artiger optischer Konzentrator, womit hierbei sowie im Folgenden ein Konzentrator gemeint ist, dessen reflektierende Seitenwände zumindest teilweise und/oder zumindest weitestgehend die Form eines zusammengesetzten parabolischen Konzentrators (compound parabolic concentrator, CPC), eines zusammengesetzten elliptischen Konzentrators (compound elliptic concentrator, CEC) und/oder eines zusammengesetzten hyperbolischen Konzentrators (compound hyperbolic concentrator, CHC) aufweist.

Dabei weist der Konzentrator zweckmäßigerweise einen Grundkörper auf, der einen Hohlraum definiert und dessen Innenwand zumindest für einen spektralen Teilbereich der elektromagnetischen Strahlung reflektierend ist.

Bei einer vorteilhaften Alternative ist der Konzentrator ein dieelektrischer Konzentrator, dessen Grundkörper ein aus einem dieelektrischen Material mit geeignetem Brechungsindex bestehender Vollkörper ist, so dass über den Strahlungseingang eingekoppelte Strahlung durch Totalreflexion an seitlichen Grenzfläche des Vollkörpers zum umgebenden Medium, die den Strahlungseingang mit dem Strahlungsausgang verbinden, reflektiert wird.

Der Strahlungsausgang des dielektrischen Konzentrator ist bevorzugt eine linsenartig gewölbte Grenzfläche des Vollkörpers, mit der eine weitere Verringerung der Divergenz erreicht werden kann.

In einer vorteilhaften Ausführungsform besteht zwischen den Halbleiterchips und dem Strahlungseingang des Konzentrators ein Spalt, der bevorzugt weitestgehend frei von fester oder flüssiger Materie ist. Dadurch kann erreicht werden, dass ein hochdivergenter Anteil der elektromagnetischen Strahlung nicht in das optische Element gelangt, wodurch die Divergenz des vom Bauelement emittierten Strahlenkegels weiter verringert werden kann, wenn auch auf Kosten der emittierten Strahlungsintensität.

Das Bauelement weist bevorzugt ein Lumineszenzkonversionselement auf, mit dem sich insbesondere weißes Licht erzeugen lässt.

In einer Ausführungsform der Erfindung ist das Lumineszenzkonversionselement mit Vorteil in eine strahlungsdurchlässige Vergussmasse eingemischt, mittels der die Halbleiterchips zumindest teilweise eingekapselt sind. Die Vergussmasse weist bevorzugt über den Halbleiterchips eine Dicke von kleiner als oder gleich 200 $\mu$m und größer als oder gleich 5 $\mu$m auf, damit die Konversion der von den Halbleiterchips emittierten Strahlung möglichst nah an den Halbleiterchips stattfindet. Dadurch kann erreicht werden, dass die elektromagnetische Strahlung für alle Abstrahlwinkel möglichst im gleichen Maße, d.h. zu einem möglichst gleichen Anteil konvertiert wird.

Alternativ ist das Lumineszenzkonversionselement mit Vorteil in einer dünnen Schicht direkt auf den Halbleiterchips aufgebracht.

Bei einer weiteren vorteilhaften alternativen Ausführungsform des Bauelements ist auf den Halbleiterchips ein strahlungsdurchlässiger Trägerkörper angeordnet, auf dem das Lumineszenzkonversionselement aufgebracht ist. Dabei ist das Lumineszenzkonversionselement bevorzugt auf einer Seite des Trägerkörpers angeordnet ist, die von den Halbleiterchips abgewandt ist.

Das Bauelement weist bevorzugt ein Diffusormaterial auf, mit dem ein hinsichtlich Farbeindruck und Strahlungsintensität möglichst homogener Strahlenkegel erzielt werden kann.

Das Leuchtmodul weist ein lichtemittierendes Bauelement gemäß einer der vorhergehend beschriebenen Ausführungsformen auf. Es ist bevorzugt ein Scheinwerfermodul, insbesondere für ein Automobil.

Das Leuchtmodul weist bevorzugt einen Überspannungsschutz für das Bauelement auf, welcher besonders bevorzugt mindestens einen Varistor umfasst.

Weitere Vorteile, bevorzugte Ausführungsformen und Weiterbildungen des Bauelements ergeben sich aus den im Folgenden in Verbindung mit den Figuren 1 bis 30 erläuterten Ausführungsbeispielen. Es zeigen:

Figur 1          eine schematische Draufsicht eines ersten Ausführungsbeispiels des Bauelementes,

Figur 2          eine schematische räumliche Darstellung eines zweiten Ausführungsbeispiels des Bauelementes,

Figur 3          eine schematische räumliche Darstellung eines dritten Ausführungsbeispiels des Bauelementes,

Figur 4          eine schematische räumliche Darstellung eines Leuchtmoduls mit einem Bauelement gemäß eines vierten Ausführungsbeispiels,

Figur 5          eine schematische räumliche Darstellung eines fünften Ausführungsbeispiels des Bauelements,

Figur 6          eine schematische Draufsicht eines sechsten Ausführungsbeispiels des Bauelements,

Figur 7          eine schematische räumliche Darstellung eines siebten Ausführungsbeispiels des Bauelements,

Figur 8          das in Figur 4 dargestellte Leuchtmodul mit einem Bauelement gemäß eines achten Ausführungsbeispiels, Figur 9 eine schematische Draufsicht eines neunten Ausführungsbeispiels des Bauelements,

Figur 10         eine schematische räumliche Darstellung eines zehnten Ausführungsbeispiels des Bauelements,

Figur 11         eine schematische Schnittansicht eines Gehäuses eines elften Ausführungsbeispiels des Bauelementes in einer Ebene senkrecht zu einer Haupterstreckungsrichtung der Anordnung der Halbleiterchips,

Figur 12         eine schematische Schnittansicht eines Gehäuses eines zwölften Ausführungsbeispiels des Bauelementes in einer Ebene senkrecht zu einer Haupterstreckungsrichtung der Anordnung der Halbleiterchips,

Figuren 13 bis 18      eine schematische Schnittansicht der Halbleiterchips eines Bauelements in einer Ebene entlang der Anordnung der Halbleiterchips gemäß verschiedenen Ausführungsbeispielen,

Figur 19      eine schematische räumliche Darstellung eines weiteren Ausführungsbeispiels eines Leuchtmoduls mit dem in Figur 5 dargestellten Bauelement,

Figur 20      eine schematische räumliche Darstellung eines weiteren Ausführungsbeispiels eines Leuchtmoduls mit einem weiteren Ausführungsbeispiel des Bauelements,

Figur 21      ein weiteres Ausführungsbeispiel eines Leuchtmoduls mit einem weiteren Ausführungsbeispiel des Bauelements,

Figur 22      eine schematische räumliche Darstellung des in Figur 21 dargestellten Scheinwerfermoduls, bei dem das Bauelement ein zusätzliches optisches Element aufweist,

Figur 23      eine schematische Draufsicht eines weiteren Ausführungsbeispiels eines Leuchtmoduls mit einem Bauelement gemäß eines weiteren Ausführungsbeispiels,

Figur 24      eine schematische Draufsicht eines weiteren Ausführungsbeispiels eines Leuchtmoduls mit einem Bauelement gemäß eines weiteren Ausführungsbeispiels,

Figuren 25 und 26      eine schematische räumliche Darstellung der in Figur 23 und 24 dargestellten Leuchtmodule, wobei das Bauelement jeweils ein zusätzliches optisches Element aufweist,

Figur 27      eine schematische räumliche Darstellung eines optischen Elements,

Figur 28      eine schematische Schnittansicht eines Teils eines Bauelementes in einer Ebene senkrecht zur Haupterstreckungsrichtung der Anordnung Halbleiterchips mit einem Ausführungsbeispiel eines optischen Elements,

Figur 29      eine schematische Schnittansicht eines Teils eines weiteren Ausführungsbeispiels des Bauelements in einer Ebene senkrecht zur Haupterstreckungsrichtung der Halbleiterchipanordnung,

Figur 30      eine schematische Schnittansicht eines Teils eines weiteren Ausführungsbeispiels des Bauelements in einer Ebene senkrecht zur Haupterstreckungsrichtung der Halbleiterchipanordnung.

In den Ausführungsbeispielen und Figuren sind gleiche oder gleichwirkende Bestandteile jeweils mit den gleichen Bezugszeichen versehen. Die dargestellten Elemente der Figuren sind nicht als maßstabsgerecht anzusehen, vielmehr können sie zum besseren Verständnis teilweise übertrieben groß dargestellt sein.

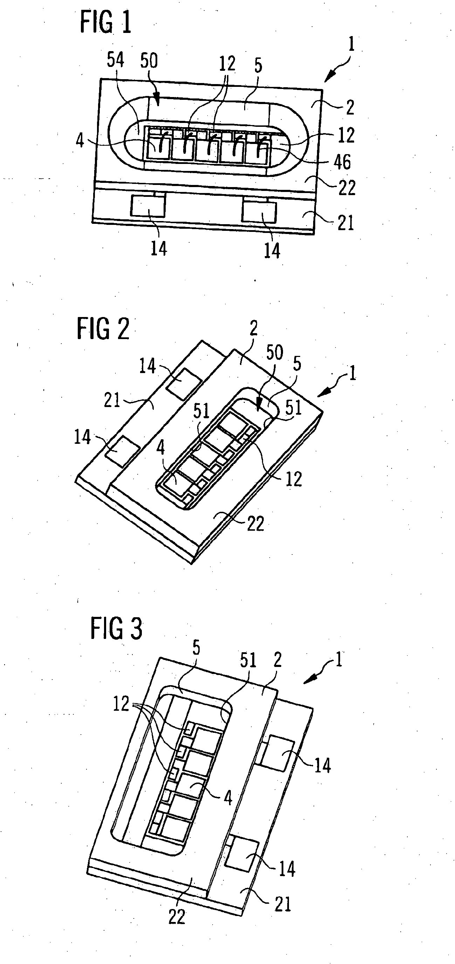

Das in Figur 1 dargestellte Bauelement weist einen Gehäusekörper 2 auf, der einen Träger 21 und einen Rahmen 22 umfasst. Der Rahmen 22 weist Innenwände 5 auf, die eine Kavität 50 begrenzen. In der grabenartig ausgebildeten Kavität 50 ist eine Mehrzahl von Halbleiterchips 4, beispielsweise fünf Stück, in einer linienförmigen Anordnung angeordnet. Bei den in den Figuren 1 bis 7 dargestellten Bauelementen 1 sind die Halbleiterchips 4 entlang einer Geraden angeordnet.

Die Innenwände 5 weisen einen relativ geringen Abstand zu den Halbleiterchips 4 auf, wobei dieser Abstand beispielsweise kleiner als oder gleich einer lateralen Kantenlänge der Halbleiterchips 4 ist. Entsprechend weist der Boden 54 der Kavität 50 eine relativ geringe Fläche auf und hat beispielsweise entlang der Anordnung der Halbleiterchips 4 eine Ausdehnung von kleiner als oder gleich einer achtfachen lateralen Kantenlänge der Halbleiterchips 4 und senkrecht zu einer Haupterstreckungsrichtung der Anordnung der Halbleiterchips eine Ausdehnung von kleiner als oder gleich der zweifachen lateralen Kantenlänge der Halbleiterchips 4.

Die Halbleiterchips 4 sind in dem Gehäusekörper 2 elektrisch montiert, wobei sie beispielsweise in Serie zueinander geschaltet sind. Hierzu weist der Boden 54 der Kavität 50 eine Mehrzahl von inneren elektrischen Kontaktflächen 12 auf, wobei die Halbleiterchips z.B. auf ihrer dem Boden 54 der Kavität 50 zugewandten Seite z.B. mittels Löten oder Leitkleber elektrisch leitend mit den entsprechenden inneren Kontaktflächen 12 verbunden sind, wobei sie auf einem Teil der jeweiligen Kontaktfläche 12 aufliegen. Eine von den inneren Kontaktflächen 12 abgewandte Seite der Halbleiterchips 4 ist z.B. mittels eines Bonddrahtes 46 mit der entsprechenden Kontaktfläche elektrisch leitend verbunden (siehe Figur 1).

Zwei der inneren Kontaktflächen 12 erstrecken sich auf dem Träger 21 bis zu einem Bereich des Trägers 21, der lateral zu dem Rahmen 22 versetzt ist, wo sie elektrisch leitend mit Außenkontakten 14 des Bauelements 1 elektrisch leitend verbunden sind, über die das Bauelement 1 extern elektrisch angeschlossen werden kann.

Die Halbleiterchips 4 emittieren bei ihrem Betrieb z.B. eine elektromagnetische Strahlung aus einem blauen oder ultravioletten Wellenlängenbereich. Bei dem in Figur 1 dargestellten Bauelement sind die Innenwände 5 des Rahmens 22 als Reflektoren für diese elektromagnetische Strahlung ausgebildet, d.h. der Rahmen 22 weist entweder ein reflektierendes Material auf, oder er ist mit einem reflektierenden Material beschichtet. Zudem verlaufen die Innenwände 5 schräg zu einer Montageebene der Halbleiterchips 4, so dass die elektromagnetische Strahlung in eine gewünschte Abstrahlrichtung reflektiert wird.

Beispielsweise weist der Rahmen Aluminiumoxid auf oder besteht aus diesem. Alternativ ist es auch möglich, dass der Rahmen ein weniger gut reflektierendes Material, wie z.B. Aluminiumnitrid oder ein Flüssigkristallpolymer (LCP), aufweist oder aus diesem besteht und zusätzlich mit einer gut reflektierenden Schicht, z.B. aus Aluminium versehen ist. Die Verwendung von LCP als ein Material für den Rahmen 22 hat den Vorteil, dass sich das Material thermisch an den Träger 21 anpassen lässt. Der Träger 21 weist als Material z.B. Aluminiumnitrid auf, welches kostengünstig ist und eine hohe Wärmeleitfähigkeit aufweist. Als alternative Materialien sind beispielsweise auch Silizium oder Siliziumcarbid möglich.

Durch den Aufbau des Gehäusekörpers mit einem Träger 21 und einem Rahmen 22 sowie mit auf dem Träger 21 aufgebrachten Kontaktflächen 12, 14 ist eine einfache Herstellung des Bauelements 1 möglich, bei der z.B. ein aufwendiges Erzeugen von Durchkontaktierungen nicht erforderlich ist. Alternativ kann der Gehäusekörper jedoch auch einstückig ausgebildet sein, beispielsweise durch Umspritzen eines Leadframes, das die jeweiligen Kontakte für die Halbleiterchips 4 und das Bauelement 1 umfasst.

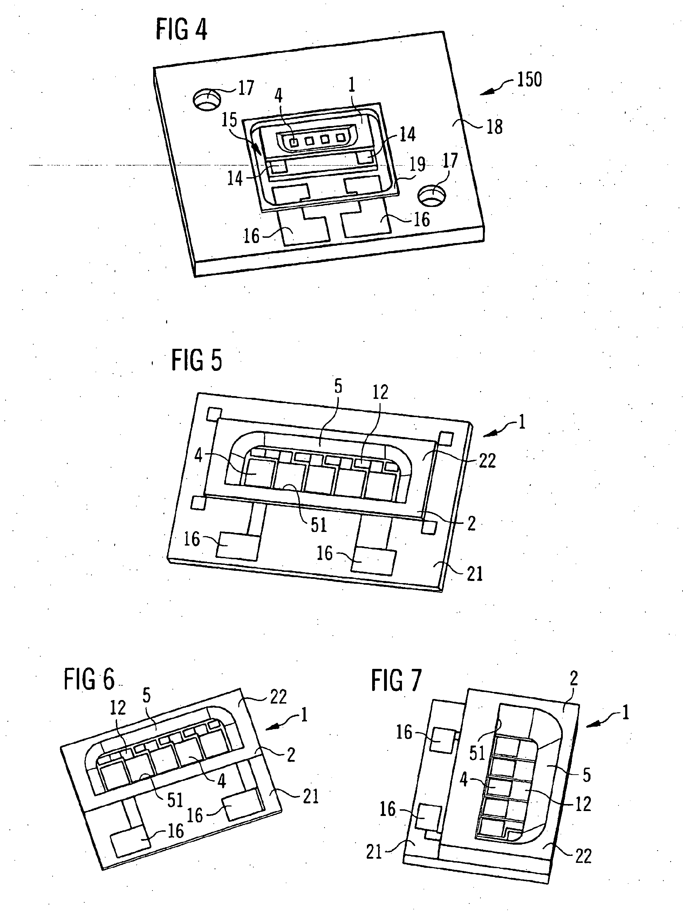

Im Unterschied zu dem vorhergehend anhand Figur 1 erläuterten Bauelement weisen die in den Figuren 2 und 3 dargestellten Bauelemente Innenwände 5 auf, die nicht schräg, sondern im wesentlichen senkrecht zu der Montagefläche der Halbleiterchips 4 verlaufen. Auch bei diesen Bauelementen 1 sind die Innenwände 5 z.B. reflektierend ausgebildet, so dass sie zumindest teilweise als eine Blendenwand 51 fungieren. Auch die in den Figuren 4 bis 10 dargestellten Bauelemente 1 weisen mindestens eine Blendenwand 51 auf, die im Unterschied zu den übrigen Abschnitten der Innenwände 5 relativ steil zu einer Montageebene der Halbleiterchips 4 verläuft. Eine Haupterstreckungsebene der Blendenwand schließt mit der Montageebene einen Winkel zwischen 80° und 110° ein. Beispielsweise verläuft die Blendenwand 51 gerade und ist im wesentlichen um einen Winkel von 90° zu der Montageebene geneigt.

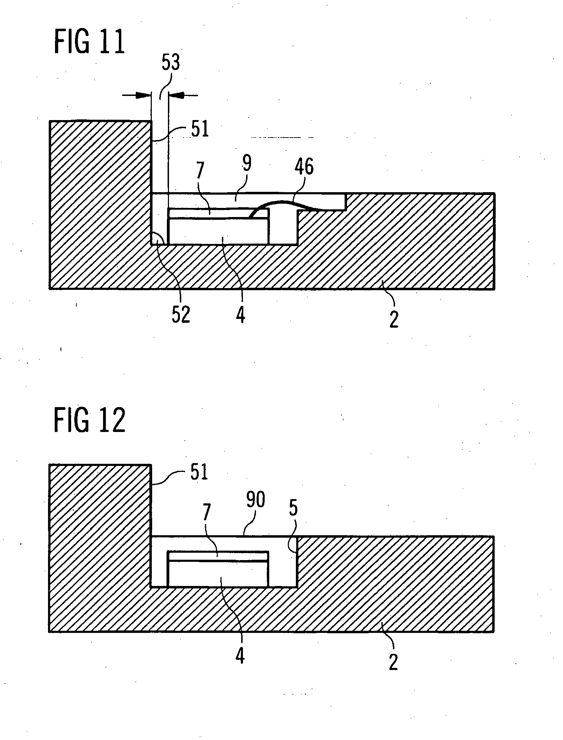

In Figur 11 ist ein Beispiel für eine derartige Blendenwand 51 in einer schematischen Schnittansicht dargestellt. Der Halbleiterchip 4 ist in einem Abstand 53 von beispielsweise 100 μm zu der Blendenwand 51 angeordnet. Bei einem derart geringen Abstand 53 kann eine effektive Blendenwirkung der Blendenwand 51 auch dann erreicht werden, wenn die Blendenwand 51 relativ niedrig ausgebildet ist, d.h. wenn sie eine geringe Höhe aufweist. Zudem trifft durch diesen geringen Abstand ein Teil der von den Halbleiterchips 4 emittierten elektromagnetischen Strahlung mit einer hohen Strahlungsintensität pro Fläche auf die Blendenwand 51, wodurch sowohl die Vermeidung von Strahlung in einem unerwünschten Raumwinkel als auch das Abstrahlen der elektromagnetischen Strahlung in einen gewünschten, bevorzugt engen Raumwinkel und mit einer hohen Strahlungsdichte ermöglicht wird.

Diese Eigenschaften sind insbesondere bei Scheinwerfern, beispielsweise bei Autoscheinwerfern, erwünscht, durch die ein bestimmter Raumwinkel möglichst hell ausgeleuchtet werden soll. Bei Autoscheinwerfern soll beispielsweise einerseits der Fahrtweg, d.h. insbesondere die Straße möglichst hell ausgeleuchtet werden, andererseits dürfen jedoch entgegenkommende Fahrzeuge nicht geblendet werden, so dass eine Abstrahlung von Licht in den oberen Raumwinkel unerwünscht und weitestgehend vermeiden ist. Eben dies kann durch ein Bauelement mit einer Blendenwand 51 erreicht werden. Zudem ermöglicht die gestreckte Anordnung der Halbleiterchips 4 eine helle und flächige, homogene Ausleuchtung des Weges bzw. der Strasse über die gesamte Breite der Strasse hinweg.

Wenn die Abstrahlung von elektromagnetischer Strahlung in einen bestimmten Raumwinkelbereich einer Raumhälfte vermieden werden soll, ist eine Ausbildung der Innenwände 5, wie sie die in den Figuren 4 bis 7 dargestellten Bauelemente 1 aufweisen, besonders vorteilhaft. Bei diesen ist ein Abschnitt der Innenwände 5 auf einer Seite entlang der Anordnung der Halbleiterchips 4 als Blendenwand 51 ausgebildet, wohingegen die übrigen Abschnitte der Innenwände 5 deutlich schräger zu der Montageebene der Halbleiterchips 4 verlaufen, beispielsweise in einem Winkel von etwa 50°.

In Figur 4 ist ein Leuchtmodul 150 dargestellt, das ein einziges Bauelement 1 aufweist. Das Bauelement 1 hat derart geringe Ausmessungen, dass es vorteilhafterweise auf eine vielfache Art eingesetzt werden kann und einfach montiert werden kann. Beispielsweise hat das Bauelement eine Länge, die kleiner als eine fünfzehnfache laterale Kantenlänge der Halbleiterchips 4 ist, und eine Breite, die kleiner als eine achtfache laterale Kantenlänge der Halbleiterchips 4 ist, wobei diese beispielhaften Abmessungen für ein Bauelement 1 mit fünf Halbleiterchips 4 gelten. Allgemein hängt die Länge des Bauelements selbstverständlich von der Anzahl der Halbleiterchips 4 ab, für die man z.B. die allgemeine Formel

$$L_{max} = k(1,5 \cdot n + 6)$$

aufstellen kann, wobei $L_{max}$ die maximale Länge des Bauelements 1, n die Anzahl der Halbleiterchips 4 und k die laterale Kantenlänge der Halbleiterchips 4 ist.

Das Leuchtmodul 150 weist einen Modulträger 18 auf, in den zwei Löcher 17 und eine Ausnehmung 15 eingebracht sind. Die Löcher 17 dienen zur mechanischen Montage und alternativ oder zusätzlich auch zum thermischen Anschließen des Leuchtmoduls. 150. Beispielsweise kann das Leuchtmodul 150 mit den Löchern 17 über einen oder zwei Montagestifte mit oder ohne Gewinde gesteckt und mit Klemmen oder Schrauben befestigt werden.

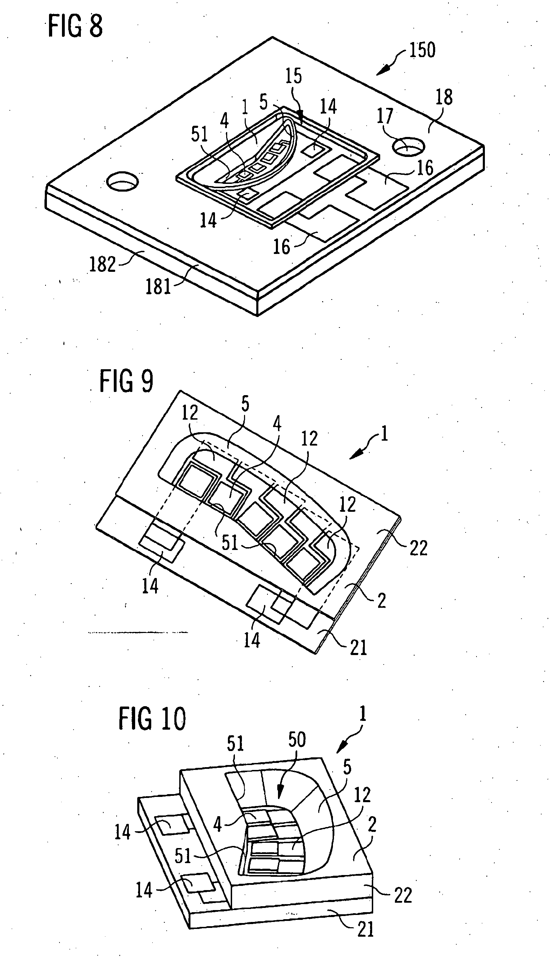

Der Modulträger 18 umfasst eine gut wärmeleitende erste Schicht 181 und eine elektrisch isolierende zweite Schicht 182, die auf der ersten Schicht aufgebracht ist (siehe Figur 8). Das Bauelement 1 ist in einer Ausnehmung der zweiten Schicht 182 auf der ersten Schicht 181 des Modulträgers 18 aufgebracht sowie mechanisch und thermisch leitend mit dieser verbunden, z.B. mittels eines Lotes oder eines Klebstoffes.

Das Leuchtmodul 150 weist zudem zwei elektrische Kontaktflächen 16 auf, von denen ein Teil innerhalb und ein weiterer Teil außerhalb eines Modulrahmens 19 liegt. Während der innere Teil der elektrischen Kontaktflächen 16 zum elektrischen Anschließen des Bauelements 1 dient, bilden die äußeren Teile der Kontaktflächen 16 Kontakte zum externen elektrischen Anschließen des Leuchtmoduls 150. Das Bauelement 1 kann insbesondere für ein Scheinwerfermodul, insbesondere auch für Automobanwendungen, verwendet werden.

Im Unterschied zu den vorhergehend anhand der Figuren 1 bis 7 erläuterter Bauelemente sind die in den Figuren 8 bis 10 dargestellten Bauelemente 1 nicht entlang nur einer, sondern entlang von zwei Geraden angeordnet, wobei diese Geraden zueinander einen Winkel von etwa 15° aufweisen. Die seitlichen Innenwände 5 weisen zwei Teilabschnitte auf, die jeweils parallel zu der angrenzenden Anordnung von Halbleiterchips verlaufen und somit ebenfalls zueinander im Winkel von etwa 15° aufweisen und die zudem als Blendenwand 51 ausgebildet sind. Ein weiterer Abschnitt der Innenwände 5 verläuft in Form eines Kreissegmentes um die Halbleiterchips 4 herum und ist bezüglich einer Montageebene der Halbleiterchips 4 deutlich schräger ausgerichtet als die Blendenwand bzw. die Blendenwände 51.

Im Unterschied zu dem in Figur 8 dargestellten Bauelement 1 weisen die in den Figuren 9 und 10 dargestellten Bauelemente 1 Innenwände auf, deren Verlauf um die Halbleiterchips 4 herum besser an die Form der Anordnung der Halbleiterchips 4 angepasst ist. Das heißt, die Innenwand 5 weist keinen Abschnitt auf, der in der Form eines Kreissegmentes um die Halbleiterchips 4 herum verläuft, sondern der entsprechende Abschnitt der Innenwände 5 ist in Form eines eng anliegenden Bogens um die Halbleiterchips 4 herum geführt. Dies ist für das Erzielen eines möglichst engen Abstrahlwinkels in Verbindung mit einer möglichst hohen Strahlungsdichte vorteilhaft.

Das Bauelement 1 emittiert zum Beispiel weißes Licht, wofür es beispielsweise ein Lumineszenzkonversionselement 7 aufweist, das die von den Halbleiterchips 4 emittierte Strahlung eines ersten Wellenlängenbereiches zumindest teilweise in eine Strahlung eines zweiten, von dem ersten Wellenlängenbereich unterschiedlichen Wellenlängenbereiches konvertiert. Weißes Licht kann entweder erzeugt werden, indem die von dem Halbleiterchip emittierte Strahlung mit der konvertierten Strahlung gemischt wird oder indem die konvertierte Strahlung Farbanteile aufweist, die zusammengemischt weißes Licht ergeben.

Das Lumineszenzkonversionsmaterial kann mindestens einen Leuchtstoff enthalten. Dazu eignen sich beispielsweise anorganische Leuchtstoffe, wie mit seltenen Erden (insbesondere Ce) dotierte Granate, oder organische Leuchtstoffe, wie Perylen-Leuchtstoffe. Weitere geeignete Leuchtstoffe sind beispielsweise in der WO 98/12757 aufgeführt, deren Inhalt insofern hiermit durch Rückbezug aufgenommen wird.

Bei den in den Figuren 11, 12, 14 und 15 ist das Lumineszenzkonversionselement 7 in Form einer dünnen Schicht direkt auf eine Strahlungsauskoppelfläche der Halbleiterchips 4 aufgebracht. Indem die Strahlungskonversion möglichst nah am Chip erwirkt wird, kann man einen möglichst homogenen resultierenden Farbeindruck erreichen, der unabhängig von einem Abstrahlwinkel der elektromagnetischen Strahlung ist. Hierfür eignen sich als Halbleiterchips 4 insbesondere Flächenstrahler, wie zum Beispiel Dünnfilm-Leuchtdiodenchips.

Ein Dünnfilm-Leuchtdiodenchip zeichnet sich insbesondere durch folgende charakteristische Merkmale aus:

- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 $\mu$m oder weniger, insbesondere im Bereich von 10 $\mu$m auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdiodenchip ist in guter Näherung ein Lambert'scher Oberflächenstrahler und eignet sich von daher besonders gut für die Anwendung in dem Bauelement, insbesondere für einen Scheinwerfer.

Bei dem in Figur 11 dargestellten Ausführungsbeispiel wird eine Seite des Halbleiterchips 4 mittels eines Bonddrahtes 46 elektrisch angeschlossen, wohingegen bei dem in Figur 12 dargestellten Ausführungsbeispiel der Halbleiterchip zum Beispiel derart ausgeführt ist, dass er beide elektrischen Kontaktflächen auf der selben Seite aufweist. Dies kann das Aufbringen einer dünnen Schicht von Lumineszenzkonversionsmaterial 7 erleichtern.

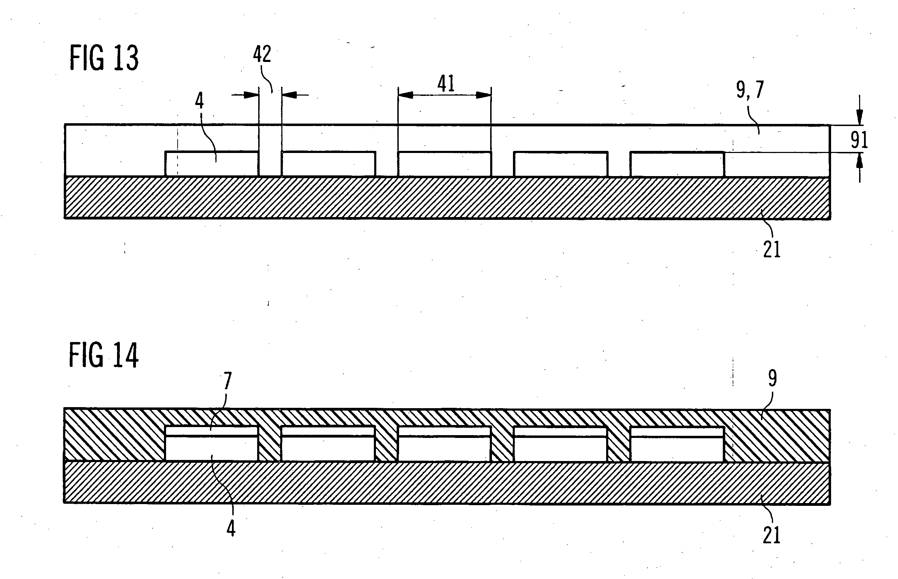

Die Halbleiterchips 4 können entweder mit einer Vergussmasse 9 (siehe Figur 11) vergossen sein, die beispielsweise auf Silikon basiert, oder mit einer strahlungsdurchlässigen Abdeckplatte 90 (siehe Figur 12) abgedeckt sein, wodurch sie vor äußeren Einflüssen geschützt sind. Alternativ oder zusätzlich zu einer unmittelbaren Aufbringung einer dünnen Schicht Lumineszenzkonversionsmaterial 7 auf die Halbleiterchips 4 kann das Lumineszenzkonversionsmaterial auch in die Vergussmasse 9 gemischt sein, mit denen die Halbleiterchips 4 vergossen sind, wie in Figur 13 dargestellt. Um bei einer derartigen Vergussmasse 9 ebenfalls einen möglichst homogenen resultierenden Farbeindruck zu erzielen, weist die Vergussmasse oberhalb der Chips eine maximale Höhe 91 von beispielsweise 50 $\mu$m auf.

In Figur 13 ist ein Abstand 42 der Chips untereinander dargestellt. Dieser beträgt beispielsweise 70 $\mu$m. Zudem ist in Figur 13 die laterale Kantenlänge 41 der Halbleiterchips 4 dargestellt. Für Scheinwerferapplikationen ist häufig eine möglichst hohe Strahlungsleistung und Strahlungsdichte erforderlich, so dass als Halbleiterchips zum Beispiel Hochleistungsleuchtdioden mit einer lateralen Kantenlänge 41 von etwa 1 mm verwendet sind, die eine elektrische Leistung von größer als mindestens 1 W, bevorzugt von größer als 2 W aufweisen. Ein Chip erzeugt beispielsweise eine Strahlungsleistung von etwa 200 Lumen. Das Bauelement 1 ist zum Beispiel mit einer elektrischen Leistung von größer als oder gleich 8 W, bevorzugt von größer als oder gleich 10 W, besonders bevorzugt von größer als oder gleich 12 W betreibbar.

Dadurch, dass die Halbleiterchips 4 in einer Reihe sowie gestreckt angeordnet sind, ist trotz des engen Abstandes der Halbleiterchips 4 zueinander eine effektive Wärmeabfuhr einer von den Halbleiterchips bei deren Betrieb erzeugten Verlustwärme möglich, da jeder Halbleiterchip maximal an zwei einander gegenüberliegenden Seiten an einen weiteren Halbleiterchip 4 angrenzt. Somit ist bei jedem Halbleiterchip zumindest an den beiden anderen, einander gegenüberliegenden Seiten eine laterale Wärmeabfuhr möglich, ohne dass sich die Wärme mehrerer Halbleiterchips 4 wesentlich staut.

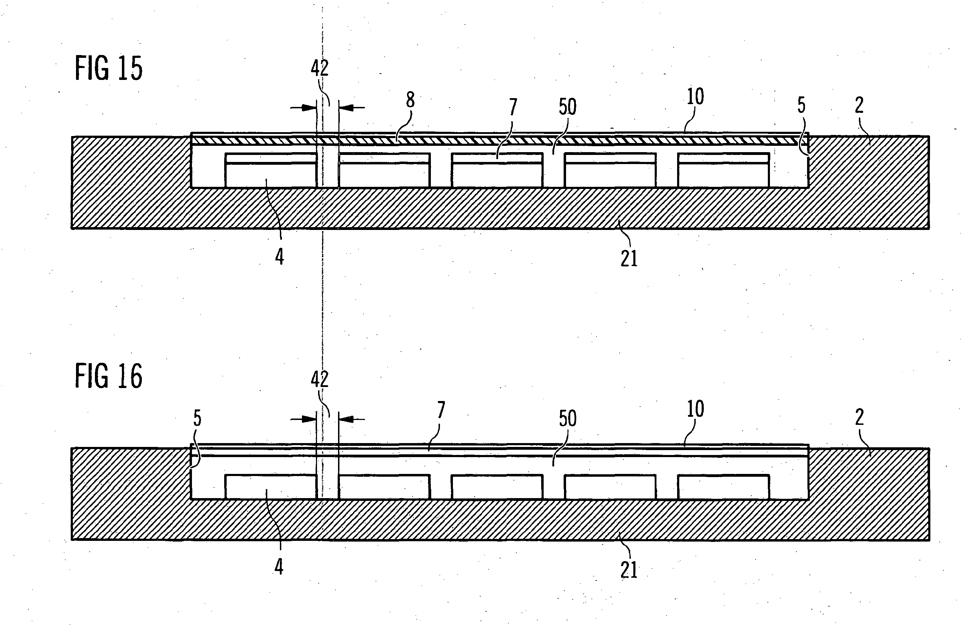

Bei dem in Figur 15 dargestellten Ausschnitt eines Bauelements sind die Halbleiterchips 4 mit einem Trägerkörper 10 bedeckt, auf dem eine Diffusorschicht 8 aufgebracht ist, die ein Diffusormaterial aufweist. Durch die Diffusorschicht 8 kann eine verbesserte Homogenität der vom Bauelement 1 emittierten elektromagnetischen Strahlung sowie eine verbesserte Durchmischung der von den Halbleiterchips 4 emittierten und von dem Lumineszenzkonversionsmaterial 7 konvertierten Strahlung erreicht werden. Der Trägerkörper 10 ist beispielsweise eine aus einem Glas gefertigte dünne Scheibe. Sie kann entweder beispielsweise mittels eines Klebstoffs unmittelbar auf den Chips aufgebracht sein oder die Kavität 50 in einem gewissen Abstand zu den Halbleiterchips 4 abdecken. Für eine verbesserte Strahlungsauskopplung ist eine freie Oberfläche des Trägerkörpers 10 oder der Diffusorschicht 9 beispielsweise aufgeraut.

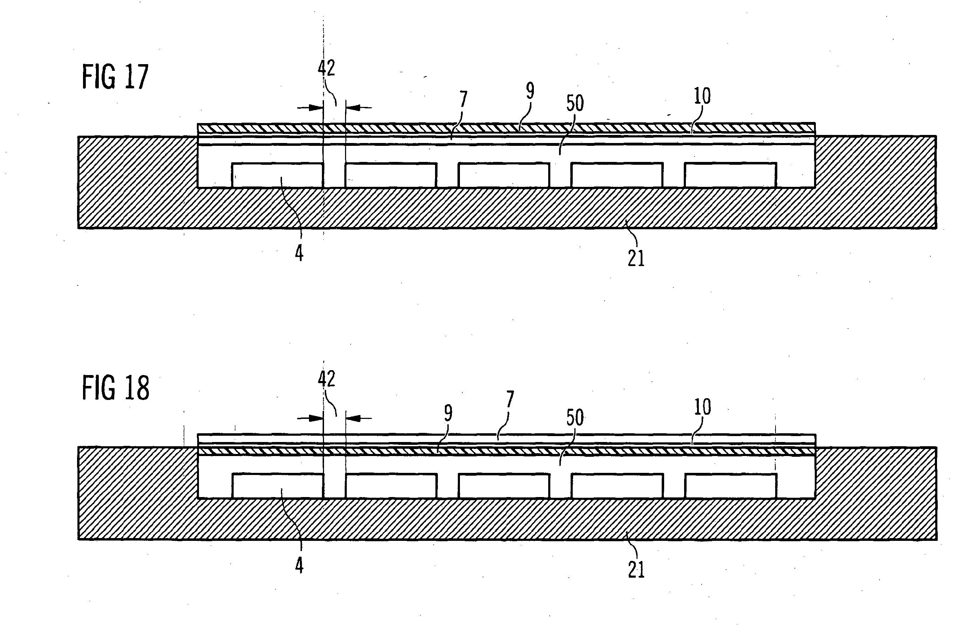

Alternativ oder zusätzliche kann auf dem Trägerkörper 10 auch eine dünne Schicht Lumineszenzkonversionsmaterial 7 aufgebracht sein (siehe Figur 16 bzw. Figuren 17 und 18). Ein Vorteil hiervon kann sein, dass die Oberfläche des Trägerkörpers 10, auf der das Lumineszenzkonversionsmaterial 7 aufgebracht wird, ebener ausgebildet werden kann als Oberflächen von Halbleiterchips, bei deren Herstellung es aufgrund von Fertigungstoleranzen zu nicht zu vernachlässigenden Unebenheiten der Oberfläche kommen kann. Dadurch lässt sich das Lumineszenzkonversionsmaterial 7 auf einem Tragerkörper 10 unter Umständen gleichmäßiger und kontrollierter aufbringen, wodurch Bauelemente mit einer verbesserten Homogenität der emittierten Strahlung erzeugt werden können.

Sind auf dem Trägerkörper 10 auf einer Seite eine Diffusorschicht 9 und auf einer anderen Seite eine Schicht Lumineszenzkonversionsmaterial 7 aufgebracht, so kann man diesen Trägerkörper derart auf oder über den Halbleiterchips aufbringen, dass den Halbleiterchips 4 entweder die Schicht Lumineszenzkonversionsmaterial 7 oder die Diffusorschicht 9 zugewandt ist. Ersteres hat den Vorteil, dass die Strahlungskonversion näher am Chip stattfindet, wodurch sich ein homogeneres Strahlungsbild erzielen lässt. Letzteres hat dagegen den Vorteil, dass die Halbleiterchips 4 und das Lumineszenzkonversionsmaterial 7 räumlich voneinander getrennt sowie besser thermisch voneinander isoliert sind. Da sowohl Leuchtstoffe als auch Halbleiterchips üblicherweise bei übermäßig hohen Temperaturen Leistungseinbuße aufweisen, als auch jeweils selbst bei Betrieb beziehungsweise bei Strahlungskonversion Wärme erzeugen, ist eine zumindest teilweise thermische Isolierung der Halbleiterchips 4 und des Lumineszenzkonversionsmaterials 7 voneinander vorteilhaft.

Der Trägerkörper 10 mit den aufgebrachten Schichten kann beispielsweise mittels eines Klebstoffs öder mittels einer Vergussmasse auf beziehungsweise über den Halbleiterchip aufgebracht sein. Zudem ist es möglich, dass zwischen den Halbleiterchips 4 und dem Trägerkörper 10 ein Raum besteht, der frei von fester oder flüssiger Materie ist.

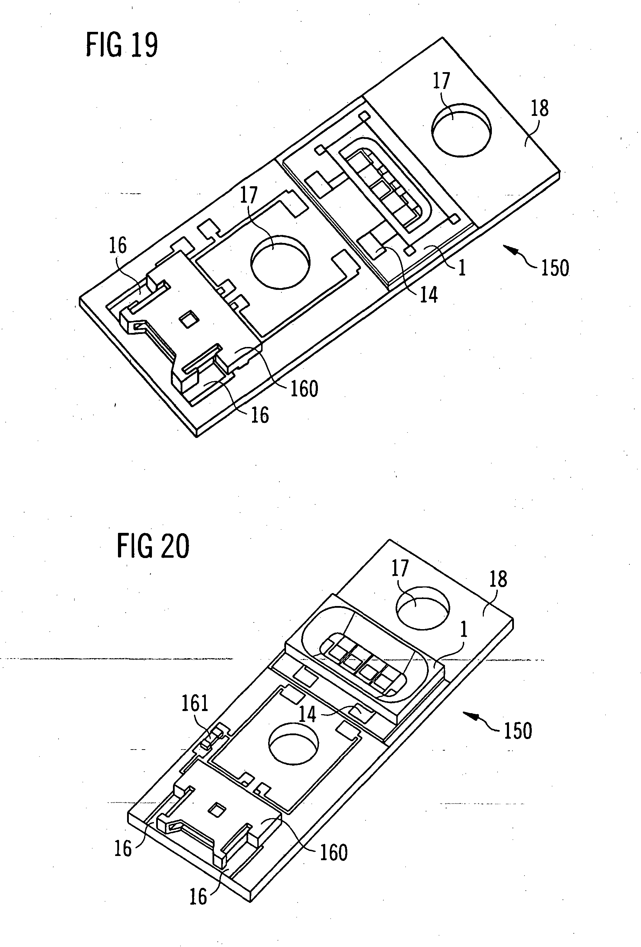

Die in den Figuren 19 bis 22 und 23 dargestellten Leuchtmodule weisen Gegenstecker 160 auf, in denen die elektrischen Kontaktflächen 16 integriert sind, so dass das Leuchtmodul mittels eines Steckers extern elektrisch kontaktiert werden kann.

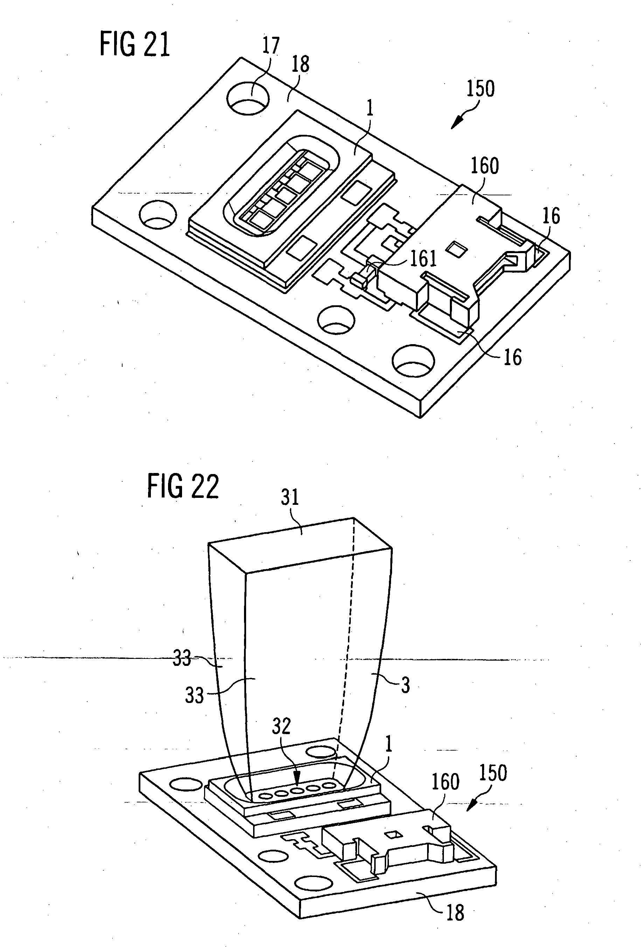

Die Leuchtmodule 150 weisen zum Beispiel einen Überspannungsschutz für die Halbleiterchips 4 auf. Ein solcher ist beispielsweise in Form von mindestens einem Varistor 161 vorgesehen, der zu dem Bauelement 1 beziehungsweise zu den Halbleiterchips 4 parallel geschaltet ist (siehe Figuren 20 und 21).

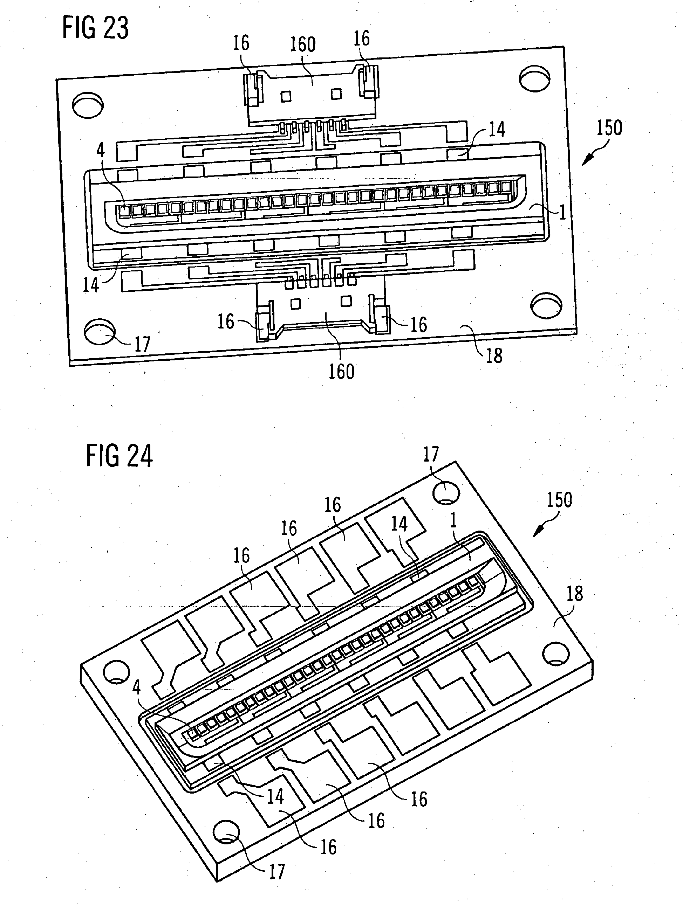

In Figur 22 ist im wesentlichen das in Figur 23 dargestellte Leuchtmodul gezeigt, mit dem Unterschied, dass das Bauelement 1 zusätzlich ein optisches Element 3 aufweist. Dieses ist zum Beispiel als ein dielektrischer Vollkörper ausgebildet, dessen Außenflächen einen Strahlungseingang 32, einen Strahlungsausgang 31 sowie den Strahlungseingang 32 mit dem Strahlungsausgang 31 verbindende Seitenwände 33 umfassen.

Das optische Element 3 ist ein nicht-abbildender optischer Konzentrator, wobei der Strahlungseingang 32 des optischen Elementes 3 der eigentliche Konzentratorausgang ist, so dass die Strahlung das optische Element 3 mit verringerter Divergenz durch den Strahlungsausgang 31 verlässt. Die Seitenwände des optischen Elements sind parabelförmig oder parabelartig gekrümmt, das heißt der Konzentrator ist ein CPC-artiger Konzentrator.

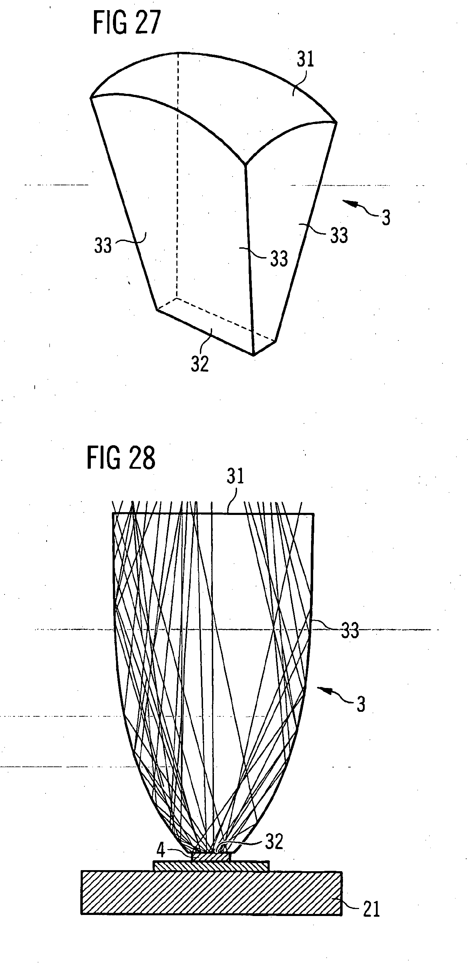

Ein derartiges optisches Element ist beispielsweise in Figur 28 in einer Schnittansicht dargestellt, wobei der Schnitt einen Teil des Bauelements 1 zeigt und senkrecht zu einer Haupterstreckungsrichtung der Anordnung der Halbleiterchips 4 verläuft. Mit diesem optischen Element 3 kann eine Divergenz der elektromagnetischen Strahlung, die in Figur 28 durch Striche angedeutet ist, in starkem Maße verringert werden. Um die Strahlungsdichte der elektromagnetischen Strahlung weitestgehend zu bewahren, ist es dabei erforderlich, das optische Element 3 beziehungsweise den Strahlungseingang 32 des optischen Elements 3 möglichst nah an eine Chipauskoppelfläche der Halbleiterchips 4 zu bringen. Beispielsweise kann der Strahlungseingang 32 direkt auf die Halbleiterchips 4 aufgebracht sein.

Alternativ ist es zum Beispiel auch möglich, dass zwischen den Halbleiterchips 4 und dem Strahlungseingang des Konzentrators ein Spalt besteht, der zum Beispiel weitestgehend frei von fester oder flüssiger Materie ist. Dadurch wird erreicht, dass insbesondere Strahlen, die in besonders großem Winkel gegenüber einer Hauptabstrahlrichtung der Halbleiterchips 4 emittiert werden und die einen aus dem Strahlungsausgang 31 emittierten Strahlungskegel zu stark aufweiten würden, nicht auf den Strahlungseingang treffen, sondern seitlich an diesem vorbeilaufen. Im Falle eines dielektrischen Konzentrators führt der Spalt dazu, dass von der Strahlung ein desto größerer Anteil an der Grenzfläche des Strahlungseingangs 32 reflektiert wird, je größer der Einfallswinkel von diesem ist. Somit wird jeweils ein hochdivergenter Anteil der auf den Strahlungseingang 32 treffenden Strahlung abgeschwächt.

Wenn man jedoch eine derartige Reflexion am Strahlungseingang 32 vermeiden möchte, so kann dieser zum Beispiel aufgeraut sein, wodurch der Anteil der in den Konzentrator beziehungsweise in das optische Element 3 gelangenden Strahlung erhöht werden kann.

Der Grundkörper des Konzentrators besteht beispielsweise aus einem transparenten Glas, Kristall oder Kunststoff und ist zum Beispiel in einem Spritzpress- oder in einem Spritzgussverfahren gefertigt.

Je näher man den Strahlungseingang 32 an die Halbleiterchips 4 heranbringt, desto kleiner kann man den Strahlungseingang 32 gestalten und desto höher ist die Strahlungsdichte der aus dem Strahlungsausgang 31 emittierten Strahlung, die erreicht werden kann. Die Breite der Strahlungseingangsfläche 32 ist beispielsweise 1,2 mal so groß wie die laterale Kantenlänge der Halbleiterchips 4.

Der Strahlungskegel, der den Strahlungsausgang 31 verlässt, weist in einer Ebene senkrecht zu einer Haupterstreckungslinie der Anordnung der Halbleiterchips einen Öffnungswinkel von beispielsweise 9° auf. Um dies zu erreichen, benötigt der CPC-artige Konzentrator eine gewisse Mindestlänge, die in Zusammenhang mit der Breite b des Strahlungseingangs 32 steht. Für einen idealen kompakten parabolischen Konzentrator gilt

$$l = b/2(1 + \sin\theta)\cos\theta/\sin^2\theta,$$

wobei l die Mindestlänge und θ der maximale Öffnungswinkel des Strahlungskegels in einer Ebene senkrecht zur Haupterstreckungslinie der Anordnung der Halbleiterchips 4 ist. Um einen maximalen Öffnungswinkel von etwa 9° zu erreichen, muss die Länge des optischen Elements 3 etwa 23 mal so groß sein wie die Breite des Strahlungseingangs. Für einen maximalen Öffnungswinkel von 15 ° muss die Länge des optischen Elements 3 etwa 9 mal so groß sein wie die Breite des Strahlungseingangs 32 und für einen Öffnungswinkel von 20 beträgt dieser Faktor etwa 5,5, für einen Öffnungswinkel von 30 ° noch etwa 2,6.

Bei einer nicht erfindungsgemäßen Abwandlung weist das optische Element 3 zum Beispiel Seitenwände auf, die in geraden Linien von dem Strahlungseingang 32 zum Strahlungsausgang 31 verlaufen. Ein Beispiel für ein derartiges optisches Element 3 ist in Figur 27 dargestellt. Es ist ein dielektrischer Konzentrator mit einer kegelstumpfartigen Grundform. Zusätzlich ist der Strahlungsausgang 31 in der Art einer sphärischen oder asphärischen Linse nach außen gewölbt. Der Vorteil einer asphärischen Wölbung verglichen mit einer sphärischen Wölbung ist, dass die asphärische Wölbung beispielsweise mit zunehmendem Abstand von der optischen Achse des optischen Elements 3 abnimmt, um den Umstand Rechnung zu tragen, dass der Strahlungskegel, dessen Divergenz durch das optische Element 3 zu verringern ist, keine punktförmige Lichtstrahlungsquelle, sondern eine Strahlungsquelle mit einer gewissen Ausdehnung ist.

Ein derartiges optisches Element hat, verglichen mit einem CPC-artigen optischen Element den Vorteil, dass mit ihm eine vergleichbare Verringerung der Divergenz eines Strahlungskegels bei gleichzeitig signifikanter Verringerung der Bauhöhe des optischen Elements 3 erzielt werden kann. Ein weiterer Vorteil des in Figur 27 dargestellten optischen Elements 3 ist, dass dieses aufgrund seiner geraden Seitenflächen 33 einfacher mittels einem Spritzverfahren wie beispielsweise Spritzgießen oder Spritzpressen hergestellt werden kann.

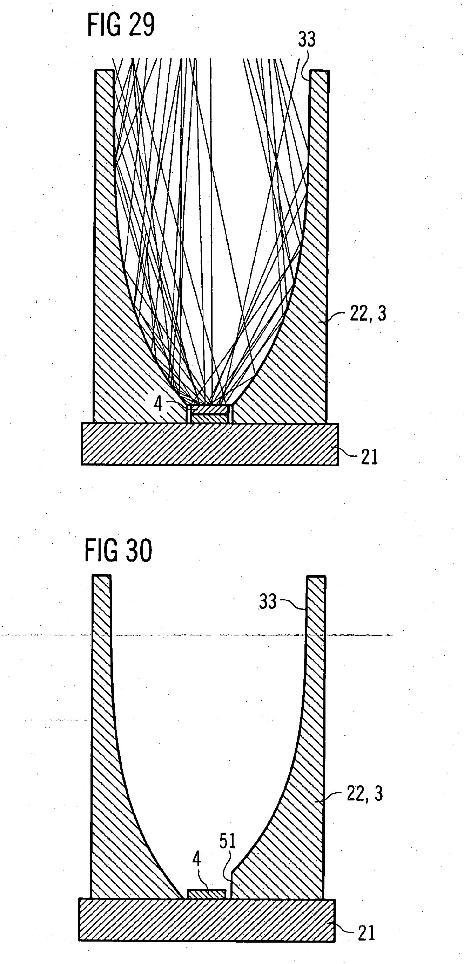

Als Alternative zu einem dielektrischen Konzentrator ist das optische Element 3 beispielsweise ein Grundkörper mit einem Hohlraum mit reflektierenden Innenwänden, wie zum Beispiel in Figuren 29 und 30 dargestellt. Das optische Element 3 kann zum Beispiel durch die Innenwände 5 des Rahmens 22 gebildet sein oder mit dem Rahmen 22 einstückig ausgebildet sein. Alternativ ist es natürlich genauso möglich, dass das optische Element ein separates Element des Bauelements ist, das in dem Rahmen oder über dem Rahmen 22 angeordnet ist. Die Innenwände des Rahmens, des Hohlraums des optischen Elements 3 sowie die Seitenwände 33 des dielektrischen Konzentrators können mit einer reflektierenden Schicht versehen sein, die beispielsweise Aluminium aufweist oder aus diesem besteht.

Der in Figur 30 dargestellte Hohlraum des optischen Elementes 3 ist nicht symmetrisch ausgebildet, wie das bei den in den Figuren 28 und 29 dargestellten optischen Elementen 3 der Fall ist. Vielmehr weisen die Innenwände 33 des optischen Elementes 3 beziehungsweise des Rahmens 22 einen Abschnitt auf, der als eine Blendenwand 51 ausgebildet ist, ähnlich wie bei den in den Figuren 4 bis 10 dargestellten Bauelementen. Die Höhe dieses als Blendenwand 51 gestalteten Abschnitts der Innenwände 33 beträgt zum Beispiel zwischen einschließlich 400 μm und einschließlich 1,5 mm, beispielsweise ist die Blendenwand 800 μm hoch. Im Anschluss an den als Blendenwand 51 ausgebildeten Abschnitt verläuft die Innenwand 33 symmetrisch zu dem gegenüberliegenden Teil der Innenwand 33.

Während die Bauelemente 1 gemäß den in den Figuren 1 bis 22 dargestellten Ausführungsbeispielen jeweils lediglich 4 oder 5 Halbleiterchips 4 aufweisen, ist es zum Beispiel auch möglich, dass das Bauelement mehr als 10, mehr als 20 oder sogar mehr als 30 Halbleiterchips 4 aufweist.

Die in den Figuren 23 und 24 dargestellten Bauelemente 1 weisen zum Beispiel 30 Halbleiterchips 4 auf. Diese sind nicht alle in Serie geschaltet, sondern sie weisen mehrere Gruppen von beispielsweise jeweils 5 Halbleiterchips 4 auf, innerhalb derer die Halbleiterchips 4 zueinander in Reihe geschaltet sind. Die einzelnen Gruppen von Halbleiterchips 4 sind parallel zueinander geschaltet. Entsprechend weisen diese Bauelemente nicht lediglich 2, sondern 12 Außenkontaktflächen 14 auf, von denen jeweils 6 auf einander gegenüberliegenden Seiten des Bauelements 1 angeordnet sind.

Selbstverständlich ist es bei dem Bauelement 1 generell möglich, die Halbleiterchips beliebig zueinander zu verschalten. Bezogen auf die vorhergehend anhand den Figuren 23 und 24 beschriebenen Bauelemente und Leuchtmodule ist für die Gruppen von Halbleiterchips eine beliebige Anzahl von Halbleiterchips sowie eine beliebige Anzahl von Gruppen. Im Grenzfall von nur einem Halbleiterchip pro Gruppe sind alle Halbleiterchips parallel zueinander geschaltet.

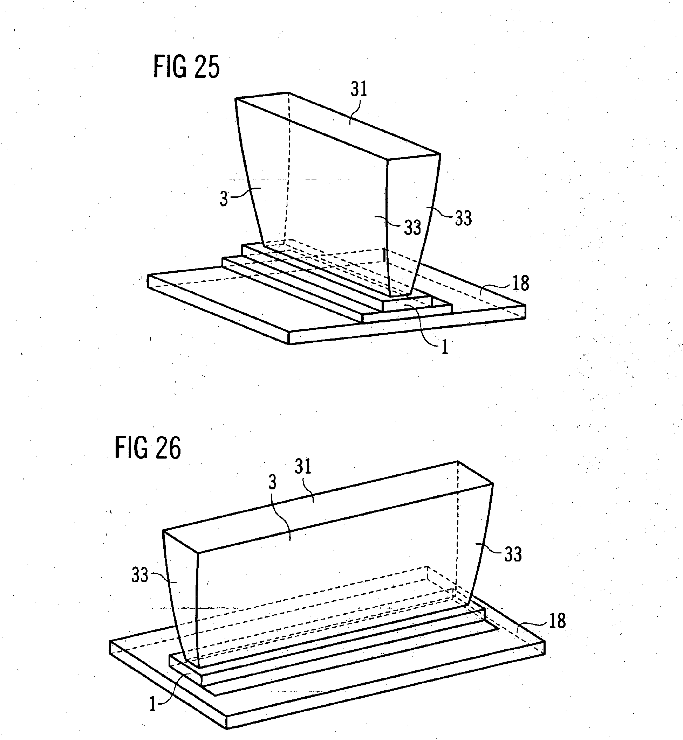

Das Modul 150 weist bei dem in Figur 23 dargestellten Ausführungsbeispiel zwei Gegenstecker 160 mit elektrischen Kontaktflächen 16 auf. Im Unterschied dazu weist das in Figur 24 dargestellte Leuchtmodul für jede Gruppe von in Reihe geschalteten Halbleiterchips 4 zwei elektrische Kontaktflächen 16 auf, so dass diese Gruppen von Halbleiterchips 4 in dem Modul unabhängig voneinander in Betrieb genommen werden können sowie mit unterschiedlichen Stromstärken betrieben werden können. Selbstverständlich können auch derartige Leuchtmodule ein optisches Element 3 aufweisen, wie das beispielsweise in den Figuren 25 und 26 dargestellt ist. Wie vorhergehend bereits erwähnt eignen sich derartige Leuchtmodule besonders für die Verwendung als Scheinwerfermodule in Automobilen.

Die Verwendung der Bauelemente 1 beziehungsweise der Leuchtmodule 150 beschränkt sich natürlich keineswegs auf KFZ-Scheinwerfer, sondern umfasst alle denkbaren Scheinwerferarten. Zudem eignet sich die Erfindung insbesondere auch für eine Projektionslichtquelle. Weitergehend können zum Beispiel die Halbleiterchips 4 zumindest teilweise unabhängig voneinander in Betrieb nehmbar sein, so dass sie für eine sequentielle Projektion verschiedener Projektionsbilder und/oder verschiedener Farben verwendet werden.

Der Schutzumfang der Erfindung ist nicht durch die Beschreibung der Erfindung anhand der Ausführungsbeispiele auf diese beschränkt. So ist es zum Beispiel nicht zwingend erforderlich, die Halbleiterchips in einer einzigen Reihe anzuordnen. Vielmehr ist es, insbesondere bei einer hohen Anzahl von Halbleiterchips, auch möglich, diese zum Beispiel in zwei Reihen anzuordnen, solang die Halbleiterchips insgesamt linienförmig angeordnet sind. Die zwei Reihen von Halbleiterchips bilden gemeinsam die Form der Linie und sind insbesondere gestreckt angeordnet. Die Erfindung umfasst jede Kombination von Merkmalen in den Patentansprüchen beinhaltet.

**Patentansprüche**

1. Lichtemittierendes Bauelement mit einem Gehäusekörper, der eine Kavität aufweist, wobei

   - die Kavität grabenartig ausgebildet ist;
   - in der Kavität eine Mehrzahl von lichtemittierenden Halbleiterchips in einer linienförmigen Anordnung angeordnet sind;
   - zwei benachbarte Halbleiterchips zueinander einen Abstand aufweisen, der kleiner als oder gleich der 1,5-fachen lateralen Kantenlänge der Halbleiterchips und größer als oder gleich 0 µm ist; und
   - mindestens ein optisches Element vorgesehen ist, das eine Divergenz des durch die Halbleiterchips emittierten Lichts verringert und den Halbleiterchips gemeinsam zugeordnet ist,

   **dadurch gekennzeichnet,**
   **dass** das optische Element ein nichtabbildender CPC-, CEC- oder CHC-Konzentrator ist.

2. Lichtemittierendes Bauelement gemäß Anspruch 1,
   **dadurch gekennzeichnet,**
   **dass** zwei benachbarte Halbleiterchips zueinander einen Abstand von kleiner als oder gleich 300 µm und größer als oder gleich 0 µm aufweisen.

3. Lichtemittierendes Bauelement gemäß Anspruch 2,
   **dadurch gekennzeichnet,**
   **dass** zwei benachbarte Halbleiterchips einen Abstand von kleiner als oder gleich 100 µm und größer als oder gleich 0 µm aufweisen.

4. Lichtemittierendes Bauelement gemäß einem der vorhergehenden Ansprüche,
   **dadurch gekennzeichnet,**
   **dass** die Halbleiterchips auf einer gedruckten Leiterplatte oder auf einem Leiterrahmen angeordnet sind.

5. Lichtemittierendes Bauelement gemäß einem der vorhergehenden Ansprüche,
   **dadurch gekennzeichnet,**
   **dass** der Gehäusekörper auf einer Seite entlang der Anordnung der Halbleiterchips eine die Kavität begrenzende Innenwand aufweist, wobei zumindest ein Abschnitt der Innenwand als eine Blendenwand ausgebildet ist, die für mindestens einen Spektralbereich des durch die Halbleiterchips emittierten Lichts reflektierend ist.

6. Lichtemittierendes Bauelement gemäß Anspruch 5 ,
   **dadurch gekennzeichnet,**
   **dass** die Blendenwand in einem Winkel von größer als oder gleich 80° und kleiner als oder gleich 110° zu einer Montageebene der Halbleiterchips verläuft.

7. Lichtemittierendes Bauelement gemäß Anspruch 5 oder 6,
   **dadurch gekennzeichnet,**
   **dass** die Halbleiterchips in einem Abstand von kleiner als oder gleich 1 mm und größer als oder gleich 0 mm zu der Blendenwand angeordnet sind.

8. Lichtemittierendes Bauelement gemäß Anspruch 5,
   **dadurch gekennzeichnet,**
   **dass** die Halbleiterchips in einem Abstand von kleiner als oder gleich 500 µm und größer als oder gleich 0 µm zu der Blendenwand angeordnet sind.

9. Lichtemittierendes Bauelement gemäß Anspruch 8,
   **dadurch gekennzeichnet,**
   **dass** die Halbleiterchips in einem Abstand von kleiner als oder gleich 150 µm und größer als oder gleich 0 µm zu der Blendenwand angeordnet sind.

10. Lichtemittierendes Bauelement gemäß einem der vorhergehenden Ansprüche,
    **dadurch gekennzeichnet,**

**dass** die Anordnung der Halbleiterchips ein erstes und ein zweites Ende aufweist, wobei an dem ersten Ende mindestens zwei Halbleiterchips entlang einer ersten Geraden angeordnet sind, die gegenüber einer zweiten Geraden geneigt ist, entlang der mindestens zwei Halbleiterchips an dem zweiten Ende angeordnet sind.

**11.** Lichtemittierendes Bauelement gemäß Anspruch 10,
**dadurch gekennzeichnet,**
**dass** die erste Gerade gegenüber der zweiten Gerade um einen Neigungswinkel von kleiner als oder gleich 20° und größer als oder gleich 10° geneigt ist.

**12.** Lichtemittierendes Bauelement gemäß einem der vorhergehenden Ansprüche,
**dadurch gekennzeichnet,**
**dass** der Strahlungseingang eine Strahlungseingangsfläche oder eine Strahlungseingangsöffnung aufweist, die eine Breite von kleiner als oder gleich 1,5 mal einer Kantenlänge der Halbleiterchips, bevorzugt von kleiner als oder gleich 1,25 mal der Kantenlänge aufweist.

**13.** Lichtemittierendes Bauelement gemäß einem der Ansprüche 1 bis 12,
**dadurch gekennzeichnet,**
**dass** das durch die Halbleiterchips emittierte Licht das optische Element in einem Strahlungskegel verlässt, der in einer Ebene senkrecht zu einer Linie, entlang der die Halbleiterchips angeordnet sind, einen Öffnungswinkel zwischen 0 und 30°, bevorzugt zwischen 0 und 20°, besonders bevorzugt zwischen 0 und 10° aufweist, wobei die Grenzen jeweils einbezogen sind.

**14.** Lichtemittierendes Bauelement nach einem der Ansprüche 1 bis 13,
**dadurch gekennzeichnet,**
**dass** der Konzentrator einen Grundkörper aufweist, der einen Hohlraum definiert und dessen Innenwand zumindest für einen spektralen Teilbereich des durch die Halbleiterchips emittierten Lichts reflektierend ist.

**15.** Lichtemittierendes Bauelement nach einem der Ansprüche 1 bis 14,
**dadurch gekennzeichnet,**
**dass** der Konzentrator ein dielektrischer Konzentrator ist, dessen Grundkörper ein aus einem dielektrischen Material mit geeignetem Brechungsindex bestehender Vollkörper ist, so dass über den Strahlungseingang eingekoppelte Strahlung durch Totalreflexion an seitlichen Grenzfläche des Vollkörpers zum umgebenden Medium, die den Strahlungseingang mit dem Strahlungsausgang verbinden, reflektiert wird.

**16.** Lichtemittierendes Bauelement nach Anspruch 15,
**dadurch gekennzeichnet,**
**dass** der Strahlungsausgang eine linsenartig gewölbte Grenzfläche des Vollkörpers ist.

**17.** Lichtemittierendes Bauelement nach einem der Ansprüche 1 bis 16,
**dadurch gekennzeichnet,**
**dass** zwischen den Halbleiterchips und dem Strahlungseingang des Konzentrators ein Spalt besteht.

**18.** Lichtemittierendes Bauelement nach Anspruch 17,
**dadurch gekennzeichnet,**
**dass** der Spalt frei von fester oder flüssiger Materie ist.

**19.** Lichtemittierendes Bauelement gemäß einem der vorhergehenden Ansprüche,
**dadurch gekennzeichnet,**
**dass** das Bauelement ein Lumineszenzkonversionselement aufweist.

**20.** Lichtemittierendes Bauelement nach Anspruch 19,
**dadurch gekennzeichnet,**
**dass** das Lumineszenzkonversionselement in einer strahlungsdurchlässigen Vergussmasse eingemischt ist, mittels der die Halbleiterchips eingekapselt sind.

**21.** Lichtemittierendes Bauelement nach Anspruch 20,
**dadurch gekennzeichnet,**
**dass** die Vergussmasse über den Halbleiterchips eine Dicke von kleiner als oder gleich 200 $\mu$m und größer als

oder gleich 5 μm aufweist.

22. Lichtemittierendes Bauelement nach Anspruch 19,
**dadurch gekennzeichnet,**
**dass** das Lumineszenzkonversionselement auf den Halbleiterchips aufgebracht ist.

23. Lichtemittierendes Bauelement nach einem der Ansprüche 19 und 22,
**dadurch gekennzeichnet,**
**dass** auf den Halbleiterchips ein strahlungsdurchlässiger Trägerkörper angeordnet ist, auf dem das Lumineszenzkonversionselement aufgebracht ist.

24. Lichtemittierendes Bauelement nach Anspruch 23, **dadurch gekennzeichnet,**
**dass** das Lumineszenzkonversionselement auf einer Seite des Trägerkörpers angeordnet ist, die von den Halbleiterchips abgewandt ist.

25. Lichtemittierendes Bauelement gemäß einem der vorhergehenden Ansprüche,
**dadurch gekennzeichnet,**
**dass** das Bauelement ein Diffusormaterial aufweist.

26. Leuchtmodul, **dadurch gekennzeichnet,**
**dass** es ein lichtemittierendes Bauelement gemäß einem der Ansprüche 1 bis 25 aufweist.

27. Leuchtmodul gemäß Anspruch 26,
**dadurch gekennzeichnet,**
**dass** das Leuchtmodul ein Scheinwerfermodul ist.

28. Leuchtmodul gemäß einem der Ansprüche 26 und 27,
**dadurch gekennzeichnet,**
**dass** ein Überspannungsschutz für das Bauelement vorgesehen ist.

29. Leuchtmodul gemäß Anspruch 28,
**dadurch gekennzeichnet,**
**dass** der Überspannungsschutz mindestens einen Varistor umfasst.


**Claims**

1. Light emitting component comprising a housing body which has a cavity,

   - the cavity being of trench-like design;
   - a plurality of light emitting semiconductor chips being arranged in the cavity in a linear arrangement;
   - two adjacent semiconductor chips having a spacing from one another which is less than or equal to 1.5 times the lateral edge length of the semiconductor chip and greater than or equal to 0 μm; and
   - at least one optical element being provided which reduces a divergence of the light emitted by the semiconductor chip and is jointly assigned to the semiconductor chips,

   **characterized in that**
   the optical element is a non-imaging CPC, CEC or CHC concentrator.

2. Light emitting component according to Claim 1, **characterized in that** two adjacent semiconductor chips have a spacing from one another of less than or equal to 300 μm and greater than or equal to 0 μm.

3. Light emitting component according to Claim 2, **characterized in that** two adjacent semiconductor chips have a spacing of less than or equal to 100 μm and greater than or equal to 0 μm.

4. Light emitting component according to one of the preceding claims, **characterized in that** the semiconductor chips are arranged on a printed circuit board or on a leadframe.

5. Light emitting component according to one of the preceding claims, **characterized in that** on one side along the arrangement of the semiconductor chips the housing body has an inner wall surrounding the cavity, at least one segment of the inner wall being designed as a diaphragm wall which is reflective for at least one spectral region of the light emitted by the semiconductor chips.

6. Light emitting component according to Claim 5, **characterized in that** the diaphragm wall runs at an angle of greater than or equal to 80° and less than or equal to 110° relative to a mounting plane of the semiconductor chips.

7. Light emitting component according to Claim 5 or 6, **characterized in that** the semiconductor chips are arranged in a spacing of less than or equal to 1 mm and greater than or equal to 0 mm relative to the diaphragm wall.

8. Light emitting component according to Claim 5, **characterized in that** the semiconductor chips are arranged at a spacing of less than or equal to 500 μm and greater than or equal to 0 μm relative to the diaphragm wall.

9. Light emitting component according to Claim 8, **characterized in that** the semiconductor chips are arranged at a spacing of less than or equal to 150 μm and greater than or equal to 0 μm relative to the diaphragm wall.

10. Light emitting component according to one of the preceding claims, **characterized in that** the arrangement of the semiconductor chips has a first and a second end, at the first end at least two semiconductor chips being arranged along a first straight line which is inclined with respect to a second straight line along which at least two semiconductor chips are arranged at the second end.

11. Light emitting component according to Claim 10, **characterized in that** the first straight line is inclined with respect to the second straight line by an angle of inclination of less than or equal to 20° and greater than or equal to 10°.

12. Light emitting component according to one of the preceding claims, **characterized in that** the radiation entrance has a radiation entrance area or a radiation entrance opening which has a width of less than or equal to 1.5 times an edge length of the semiconductor chips, preferably of less than or equal to 1.25 times the edge length.

13. Light emitting component according to one of Claims 1 to 12, **characterized in that** the light emitted by the semiconductor chips leaves the optical element in a radiation cone which has an aperture angle between 0 and 30°, preferably between 0 and 20°, particularly preferably between 0 and 10°, including the limits in each case, in a plane perpendicular to a line along which the semiconductor chips are arranged.

14. Light emitting component according to one of Claims 1 to 13, **characterized in that** the concentrator has a base body which defines a cavity and whose inner wall is reflective at least for a spectral subregion.

15. Light emitting component according to one of Claims 1 to 14, **characterized in that** the concentrator is a dielectric concentrator the base body of which is a solid body consisting of a dielectric material having a suitable index of refraction so that radiation coupled in via the radiation entrance is reflected by a total reflection on lateral boundary faces on the solid body to the surrounding medium which connect the radiation entrance to the radiation exit.

16. Light emitting component according to Claim 15, **characterized in that** the radiation exit is a boundary face of the solid body which is curved in the manner of a lens.

17. Light emitting component according to one of Claims 1 to 16, **characterized in that** a gap exists between the semiconductor chips and the radiation entrance of the concentrator.

18. Light emitting component according to Claim 17, **characterized in that** the gap is free of solid or aqueous material.

19. Light emitting component according to one of the preceding claims, **characterized in that** the component has a luminescence conversion element.

20. Light emitting component according to Claim 19, **characterized in that** the luminescence conversion element is intermixed in a casting compound transparent to radiation by means of which the semiconductor chips are encapsulated.

21. Light emitting component according to Claim 20, **characterized in that** the casting compound has a thickness of less than or equal to 200 μm and greater than or equal to 5 μm over the semiconductor chips.

22. Light emitting component according to Claim 19, **characterized in that** the luminescence conversion element is applied to the semiconductor chips.

23. Light emitting component according to either of Claims 19 and 22, **characterized in that** a carrier body transparent to radiation, on which the luminescence conversion element is applied, is arranged on the semiconductor chips.

24. Light emitting component according to Claim 23, **characterized in that** the luminescence conversion element is arranged on a side of the carrier body which is averted from the semiconductor chips.

25. Light emitting component according to one of the preceding claims, **characterized in that** the component has a diffuser material.

26. Illumination module **characterized in that** it has a light emitting component in accordance with one of Claims 1 to 25.

27. Illumination module according to Claim 26, **characterized in that** the illumination module is a headlamp module.

28. Illumination module according to either of Claims 26 and 27, **characterized in that** overvoltage protection is provided for the component.

29. Illumination module according to Claim 28, **characterized in that** the overvoltage protection comprises at least one varistor.


**Revendications**

1. Elément électroluminescent comportant un corps de boîtier qui comprend une cavité, dans lequel

- la cavité est réalisée à la façon d'une tranchée ;
- une pluralité de puces à semi-conducteur électroluminescentes sont disposées selon un agencement linéaire dans la cavité ;
- deux puces à semi-conducteur voisines sont espacées l'une de l'autre d'une distance qui est inférieure ou égale à 1,5 fois les longueurs des côtés latéraux des puces à semi-conducteur et est supérieure ou égale à 0 μm ; et
- il est prévu au moins un élément optique qui réduit la divergence de la lumière émise par les puces à semi-conducteur et est associé en commun aux puces à semi-conducteur, **caractérisé en ce que**

l'élément otique est un concentrateur CPC, CEC, ou CHC ne formant pas d'image.

2. Elément électroluminescent selon la revendication 1, **caractérisé en ce que**
deux puces à semi-conducteur voisines sont à une distance l'une de l'autre inférieure ou égale à 300 μm ou supérieure ou égale à 0 μm.

3. Elément électroluminescent selon la revendication 2, **caractérisé en ce que**
deux puces à semi-conducteur voisines sont à une distance inférieure ou égale à 100 μm et supérieure ou égale à 0 μm.

4. Elément électroluminescent selon l'une quelconque des revendications précédentes, **caractérisé en ce que**
les puces à semi-conducteur sont disposées sur un circuit imprimé ou sur une grille de connexion.

5. Elément électroluminescent selon l'une quelconque des revendications précédentes, **caractérisé en ce que**
le corps de boîtier présente sur une face, le long de l'agencement des puces à semi-conducteur, une paroi interne délimitant la cavité, dans lequel au moins une section de la paroi interne est réalisée sous la forme d'une paroi formant écran qui est réfléchissante pour au moins une région spectrale de la lumière émise par les puces à semi-conducteur.

6. Elément électroluminescent selon la revendication 5, **caractérisé en ce que**

la paroi formant écran s'étend en formant un angle supérieur ou égal à 80° et inférieur ou égal à 110° par rapport à un plan de montage des puces à semi-conducteur.

7. Elément électroluminescent selon la revendication 5 ou 6, **caractérisé en ce que** les puces à semi-conducteur sont disposées à une distance inférieure ou égale à 1 mm, et supérieure ou égale à 0 mm de la paroi formant écran.

8. Elément électroluminescent selon la revendication 5, **caractérisé en ce que**
les puces à semi-conducteur sont disposées à une distance inférieure ou égale à 500 $\mu$m, et supérieure ou égale à 0 $\mu$m de la paroi formant écran.

9. Elément électroluminescent selon la revendication 8, **caractérisé en ce que**
les puces à semi-conducteur sont disposées à une distance inférieure ou égale à 150 $\mu$m, et supérieure ou égale à 0 $\mu$m de la paroi formant écran.

10. Elément électroluminescent selon l'une quelconque des revendications précédentes, **caractérisé en ce que**
l'agencement des puces à semi-conducteur présente des première et seconde extrémités, dans lequel, à la première extrémité, au moins deux puces à semi-conducteur sont disposées le long d'une première droite qui est inclinée par rapport à une seconde droite le long de laquelle au moins deux puces sont disposées à la seconde extrémité.

11. Elément électroluminescent selon la revendication 10, **caractérisé en ce que**
la première droite est inclinée par rapport à la seconde droite d'un angle d'inclinaison inférieur ou égal à 20° et supérieur ou égal à 10°.

12. Elément électroluminescent selon l'une quelconque des revendications précédentes, **caractérisé en ce que**
l'entrée de rayonnement comprend une surface d'entrée de rayonnement ou une ouverture d'entrée de rayonnement qui présente une largeur inférieure ou égale à 1,5 fois une longueur du côté des puces à semi-conducteur, de préférence inférieure ou égale à 1,25 fois la longueur du côté.

13. Elément électroluminescent selon l'une quelconque des revendications 1 à 12, **caractérisé en ce que**
la lumière émise par la puce à semi-conducteur émane de l'élément optique dans un cône de rayonnement qui présente un angle d'ouverture dans un plan perpendiculaire à une ligne le long de laquelle sont disposées les puces à semi-conducteur, compris entre 0 et 30°, de préférence entre 0 et 20° et plus préférablement, entre 0 et 10°, les limites étant toutes incluses.

14. Elément électroluminescent selon l'une quelconque des revendications 1 à 13, **caractérisé en ce que**
le concentrateur comprend un corps de base qui définit un espace creux et dont la paroi interne est réfléchissante pour au moins une région spectrale de la lumière émise par les puces à semi-conducteur.

15. Elément électroluminescent selon l'une quelconque des revendications 1 à 14, **caractérisé en ce que**
le concentrateur est un concentrateur diélectrique dont le corps de base est un corps plein constitué d'un matériau diélectrique possédant un indice de réfraction approprié de manière à ce qu'un rayonnement injecté par l'intermédiaire de l'entrée de rayonnement soit réfléchi par réflexion totale sur des surfaces limites latérales du port plein vers du milieu ambiant qui relient l'entrée de rayonnement à la sortie de rayonnement.

16. Elément électroluminescent selon la revendication 15, **caractérisé en ce que**
la sortie de rayonnement est une surface limite du corps plein incurvée à la manière d'une lentille.

17. Elément électroluminescent selon l'une quelconque des revendications 1 à 16, **caractérisé en ce que**,
entre les puces à semi-conducteur et l'entrée de rayonnement du concentrateur, se trouve une fente.

18. Elément électroluminescent selon la revendication 17, **caractérisé en ce que**
la fente est exempte de matière solide ou liquide.

19. Elément électroluminescent selon l'une quelconque des revendications précédentes, **caractérisé en ce que**
l'élément comprend un élément de conversion de luminescence.

20. Elément électroluminescent selon la revendication 19, **caractérisé en ce que**
l'élément de conversion de luminescence est incorporé à une masse de coulée transparente au rayonnement au moyen de laquelle les puces à semi-conducteur sont encapsulées.

21. Elément électroluminescent selon la revendication 20, **caractérisé en ce que**
la masse de coulée se trouvant sur les puces à semi-conducteur présente une épaisseur inférieure ou égale à 200 $\mu$m, et supérieure ou égale à 5 $\mu$m.

22. Elément électroluminescent selon la revendication 19, **caractérisé en ce que**
l'élément de conversion de luminescence est déposé sur les puces à semi-conducteur.

23. Elément électroluminescent selon l'une quelconque des revendications 19 et 22, **caractérisé en ce qu'**un corps de support transparent au rayonnement sur lequel est déposé l'élément de conversion de luminescence est disposé sur les puces à semi-conducteur.

24. Elément électroluminescent selon la revendication 23, **caractérisé en ce que**
l'élément de conversion de luminescence est disposé sur une face du corps de support qui est opposée aux puces à semi-conducteur.

25. Elément électroluminescent selon l'une quelconque des revendications précédentes, **caractérisé en ce que**
l'élément comprend un matériau diffusant.

26. Module lumineux **caractérisé
en ce qu'**il comprend un élément électroluminescent selon l'une quelconque des revendications 1 à 25.

27. Module lumineux selon la revendication 26, **caractérisé en ce que**
le module lumineux est un module de projecteur.

28. Module lumineux selon l'une quelconque des revendications 26 et 27, **caractérisé
en ce qu'**un dispositif de protection contre les surtensions est prévu pour l'élément.

29. Module lumineux selon la revendication 28, **caractérisé en ce que**
le dispositif de protection contre les surtensions comprend au moins une varistance.

FIG 1

FIG 2

FIG 3

**FIG 4**

**FIG 5**

**FIG 6**

**FIG 7**

**FIG 8**

**FIG 9**

**FIG 10**

FIG 11

FIG 12

EP 1 771 891 B1

**FIG 13**

**FIG 14**

EP 1 771 891 B1

FIG 15

FIG 16

FIG 17

FIG 18

## FIG 19

## FIG 20

FIG 21

FIG 22

FIG 23

FIG 24

FIG 25

FIG 26

## FIG 27

## FIG 28

FIG 29

FIG 30

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0933823 A2
- JP 2003031011 A
- EP 1103759 A2
- US 5727108 A
- WO 9812757 A

**In der Beschreibung aufgeführte Nicht-Patentliteratur**

- **I. SCHNITZER et al.** *Appl. Phys. Lett.,* 18. Oktober 1993, vol. 63 (16), 2174-2176